# EUROPEAN PATENT SPECIFICATION

(11) **EP 4 561 278 B1**
(45) Date of publication and mention of the grant of the patent: **03.06.2026**
(21) Application number: 24186201.0
(22) Date of filing: 03.07.2024
(51) Int. Cl.: A47B 88/43, H05K 7/14

(54) **FITTING ASSEMBLY AND FITTING DEVICE THEREOF**
BESCHLAGANORDNUNG UND BESCHLAGVORRICHTUNG DAFÜR
ENSEMBLE RACCORD ET SON DISPOSITIF DE RACCORD

(30) Priority: 21.11.2023 TW 112145265
(43) Date of publication of application: 28.05.2025
(73) Proprietor: King Slide Works Co., Ltd., Kaohsiung City 821010 (TW); King Slide Technology Co., Ltd., Kaohsiung City 821011 (TW)
(72) Inventor: CHEN, Ken-Ching, 821010 Kaohsiung City (TW); YANG, Shun-Ho, 821010 Kaohsiung City (TW); WENG, Tzu-Cheng, 821010 Kaohsiung City (TW); WANG, Chun-Chiang, 821010 Kaohsiung City (TW)
(74) Representative: Viering, Jentschura & Partner mbB Patent- und Rechtsanwälte

(56) References cited:
- EP-A1- 3 750 446
- EP-A1- 3 975 674
- EP-B1- 1 403 970

## Description

### Field of the Invention

The present invention is related to a fitting device.

### Background of the Invention

US patent number US 10,314,394B2 discloses a rack system comprising a rack, a first adapter mechanism and a second adapter mechanism. The rack has a first side and a second side. A first width is defined between the first side and the second side. The first adapter mechanism is detachably mounted to the first side of the rack. The second adapter mechanism is detachably mounted to the second side of the rack. A second width is defined between the first adapter mechanism and the second adapter mechanism, and the second width is smaller than the first width. The slide rail assemblies in the patent are configured to be mounted to the rack through the first adapter mechanism and the second adapter mechanism. In other words, the slide rail assemblies are mounted within a space having the second width smaller than the first width through the first adapter mechanism and the second adapter mechanism. A second side plate of an end part of the first adapter mechanism (or the second adapter mechanism) is configured to be engaged between two of a plurality of mounting features of the rack.

However, for different market requirements, it is important to develop various products.

EP 3975674 A1 discloses a slide rail kit applicable to a rack. The rack includes at least one mounting structure having a first predetermined portion and a second predetermined portion. The slide rail kit includes a rail member and a supporting bracket. The supporting bracket is arranged on the rail member and includes a first mounting feature and a second mounting feature. The first mounting feature is configured to be mounted to the first predetermined portion of the rack. The second mounting feature includes an elastic member and a mounting member arranged on the elastic member. The mounting member can be mounted to the second predetermined portion of the rack in response to an elastic force of the elastic member.

EP 1403970 B1 discloses an attachment arrangement having at least one mounting plate on the housing wall for engaging a leg end of the mounting rail and at least one latching hook for engaging the opposing leg end for reversible attachment to the mounting rail.

EP 3 750 446 A1 discloses a slide rail assembly including a first rail, a second rail, a third rail, a locking member, and an operating member. The second rail is displaceable with respect to the first rail from a first position to a second position. The third rail is displaceable with respect to the second rail. The locking member can prevent the second rail from displacement with respect to the first rail from the second position toward the first position when in a first state. The operating member can be operated in order to switch the locking member from the first state to a second state, in which the second rail is displaceable with respect to the first rail from the second position toward the first position.

### Summary of the Invention

This in mind, the present invention aims at providing a fitting device.

This is achieved by a fitting device according to claim 1. The dependent claims pertain to corresponding further developments and improvements.

As will be seen more clearly from the detailed description following below, a fitting assembly according to an example useful for understanding but not forming part of the present invention is configured to be mounted to a rack comprising a first side frame and a second side frame. A first width is defined between the first side frame and the second side frame. The fitting assembly comprises a first fitting device and a second fitting device. The first fitting device is configured to be mounted to the first side frame of the rack. The second fitting device is configured to be mounted to the second side frame of the rack. A second width defined between the first fitting device and the second fitting device is smaller than the first width. The first fitting device and the second fitting device are configured to mount a first slide rail assembly and a second slide rail assembly to the first side frame and the second side frame respectively. The first fitting device comprises a first end part, a second end part and a main body part connected between the first end part and the second end part, and the main body part is arranged with an engaging structure configured to be engaged to the first side frame of the rack.

As will be seen more clearly from the detailed description following below, the claimed fitting device is configured to be mounted to a rack. The fitting device comprises a first end part, a second end part, a main body part connected between the first end part and the second end part, a locking member, a mounting feature and an operating member. The main body part is arranged with an engaging structure configured be engaged to the rack. The locking member is arranged on the main body part. The mounting feature is arranged on the locking member and configured to lock the engaging structure to the rack, in order to prevent the engaging structure from being disengaged from the rack. The operating member is configured to drive the locking member to move.

### Brief Description of the Drawings

In the following, the invention is further illustrated by way of example, taking reference to the accompanying drawings thereof:
FIG. 1 is a diagram showing a fitting assembly applicable to a rack according to an example useful for understanding but not forming part of the present invention;
FIG. 2 is a diagram showing the fitting assembly applicable to the rack according to the example;
FIG. 3 is a diagram showing a fitting device of the fitting assembly being locked to the rack according to the example;
FIG. 4 is a diagram showing the fitting device of the fitting assembly being locked to the rack in another viewing angle according to the example;
FIG. 5 is a diagram showing the fitting device no longer being locked to the rack according to the example;
FIG. 6 is a diagram showing the fitting device on the rack and a slide rail assembly according to the example;
FIG. 7 is a diagram showing the slide rail assembly being mounted to the rack through the fitting device according to the example;
FIG. 8 is a diagram showing a fitting device according to an embodiment of the present invention;
FIG. 9 is a diagram showing the fitting device in another viewing angle according to the embodiment of the present invention;
FIG. 10 is a diagram showing the fitting device being locked to the rack according to the embodiment of the present invention;
FIG. 11 is a diagram showing the fitting device being locked to the rack in another viewing angle according to the embodiment of the present invention;
FIG. 12 is a diagram showing the fitting device no longer being locked to the rack according to the embodiment of the present invention;
FIG. 13 is a diagram showing the fitting device no longer being locked to the rack in another viewing angle according to the embodiment of the present invention; and
FIG. 14 is a diagram showing a slide rail assembly being mounted to the rack through the fitting device according to the embodiment of the present invention.

### Detailed Description

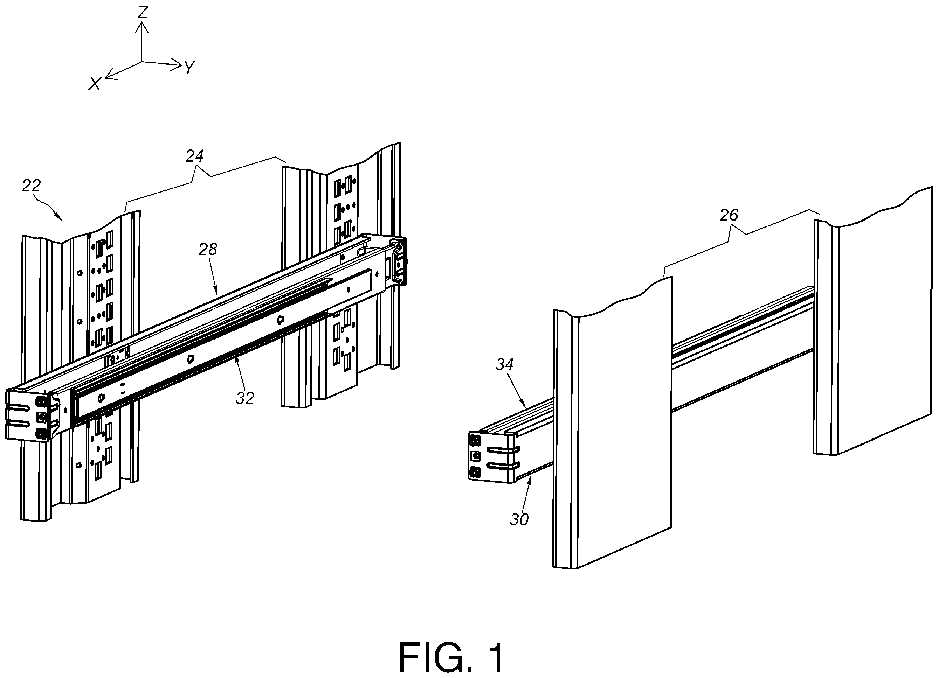

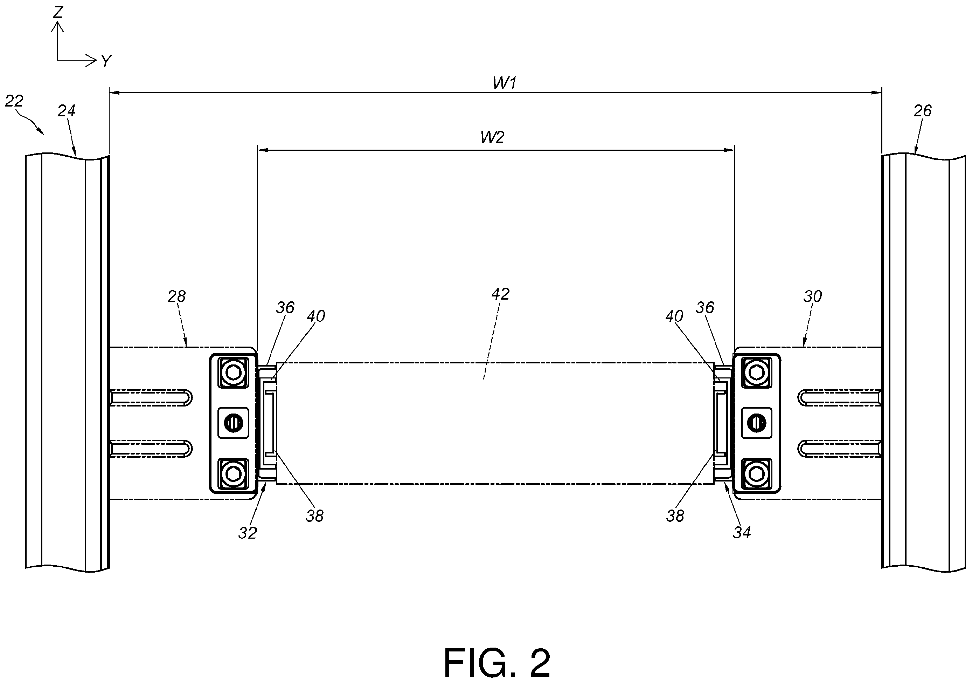

As shown in FIG. 1 and FIG. 2, a fitting assembly is applicable to a rack 22 (or a cabinet) according to an example useful for understanding but not forming part of the present invention. The rack 22 comprises a first side frame 24 and a second side frame 26, such as a left side frame and a right side frame. Structural configuration of the first side frame 24 is substantially identical to or symmetric to structural configuration of the second side frame 26, but the present invention is not limited thereto. A first width W1 is defined between the first side frame 24 and the second side frame 26 of the rack 22.

The fitting assembly comprises a first fitting device 28 and a second fitting device 30. Structural configuration of the first fitting device 28 is substantially identical to or symmetric to structural configuration of the second fitting device 30, but the present invention is not limited thereto. The first fitting device 28 is configured to be mounted to the first side frame 24 of the rack 22, and the second fitting device 30 is configured to be mounted to the second side frame 26 of the rack 22. The manner of mounting the first fitting device 28 to the first side frame 24 is substantially identical to the manner of mounting the second fitting device 30 to the second side frame 26. A second width W2 is defined between the first fitting device 28 and the second fitting device 30, and the second width W2 is smaller than the first width W1.

The first fitting device 28 and the second fitting device 30 are configured to mount a first slide rail assembly 32 and a second slide rail assembly 34 to the first side frame 24 and the second side frame 26 respectively. Structural configuration of the first slide rail assembly 32 is substantially identical to or symmetric to structural configuration of the second slide rail assembly 34. For example, each of the first slide rail assembly 32 and the second slide rail assembly 34 comprises a first rail 36 (outer rail), a second rail 38 (inner rail), and a third rail 40 (middle rail) movably mounted between the first rail 36 and the second rail 38. However, the number of slide rails is not limited in the present invention. Preferably, a carried object 42 (as shown in FIG. 2) is configured to be carried by the second rail 38 of the first slide rail assembly 32 and the second rail 38 of the second slide rail assembly 34, and a slide assisting device is arranged between each two slide rails (such as the first rail 36 and the third rail 40, or the third rail 40 and the second rail 38) to facilitate relative longitudinal movement between each two slide rails. In the figures, the X axis is a longitudinal direction (or a length direction of the slide rail), the Y axis is a transverse direction (or a lateral direction of the slide rail), and the Z axis is a vertical direction (or a height direction of the slide rail).

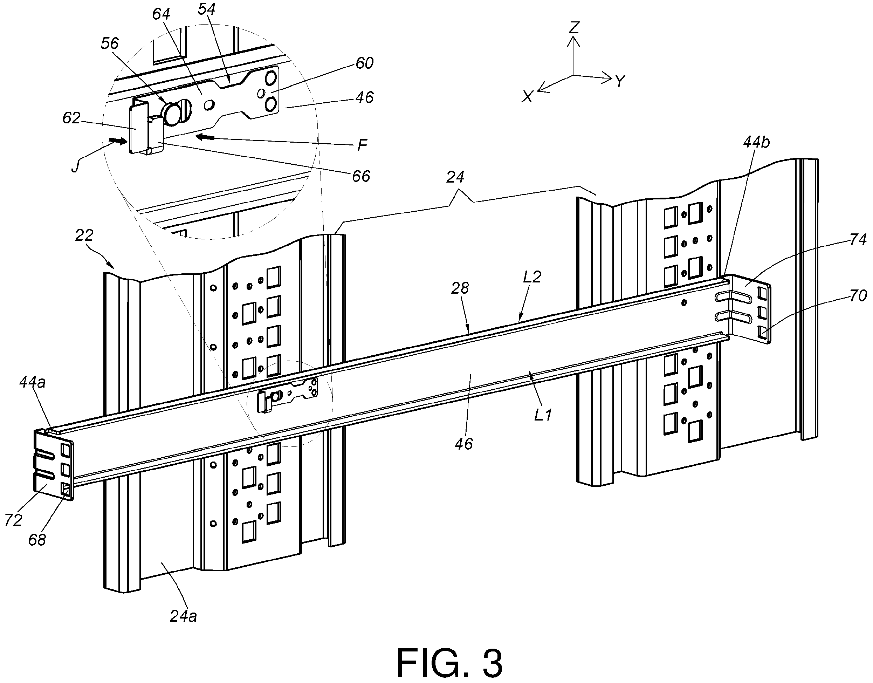

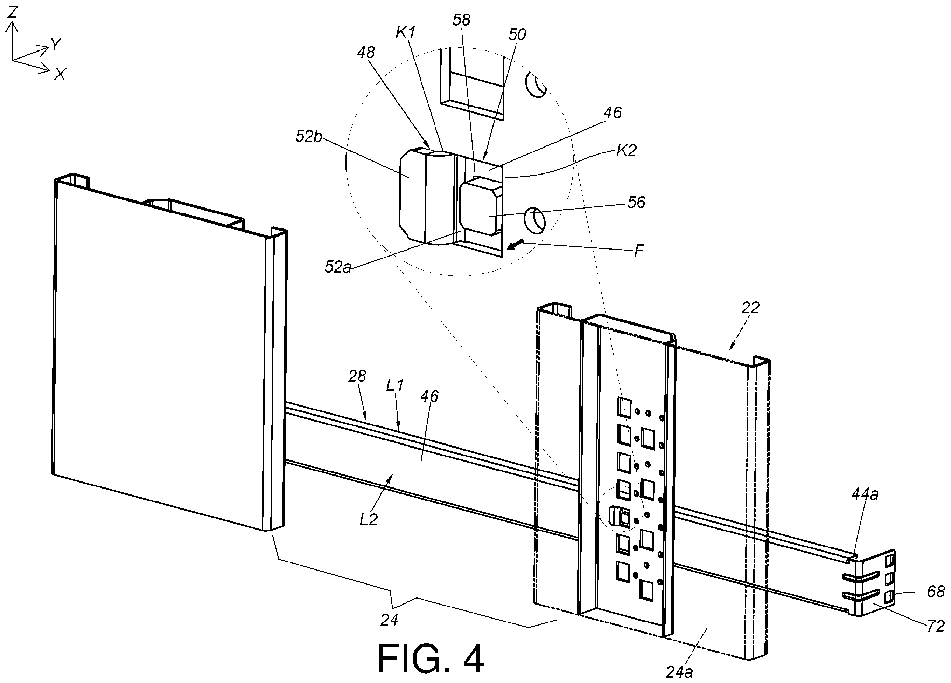

As shown in FIG. 3 and FIG. 4, the first fitting device 28 comprises a first end part 44a, a second end part 44b and a main body part 46 (longitudinal part) connected between the first end part 44a and the second end part 44b. The main body part 46 is arranged with at least one engaging structure 48 configured to be engaged to at least one post 24a (as shown in FIG. 4) of the first side frame 24 of the rack 22. For example, the post 24a of the first side frame 24 of the rack 22 comprises a plurality of mounting parts 50. The mounting parts 50 are arranged at intervals along the height direction of the post 24a of the rack 22. In the present example, the mounting parts 50 are holes, such as square holes, but the present invention is not limited thereto.

Furthermore, the main body part 46 has an inner side L1 and an outer side L2 opposite to each other. In the present example, the engaging structure 48 is arranged at the outer side L2 of the main body part 46, and the engaging structure 48 is an insertion structure. The engaging structure 48 has a first section 52a and a second section 52b (as shown in FIG. 4). The first section 52a is transversely (laterally) connected to the main body part 46, and the second section 52b is bent relative to the first section 52a. Preferably, the second section 52b is substantially perpendicularly connected to the first section 52a. The engaging structure 48 is configured to be inserted into the mounting part 50 (hole) of the rack 22, such that the second section 52b of the engaging structure 48 can be further engaged with a first wall K1 (first hole wall) of the mounting part 50.

Preferably, the main body part 46 is further arranged with a locking member 54 and a mounting feature 56 arranged on the locking member 54. The mounting feature 56 is configured to lock the engaging structure 48 to the first side frame 24 of the rack 22, in order to prevent the engaging structure 48 from being disengaged from the first side frame 24 of the rack 22 (as shown in FIG. 4). The locking member 54 is arranged at the inner side L1 of the main body part 46, and the mounting feature 56 is a protruded structure (or extended structure) . The mounting feature 56 is configured to pass through an auxiliary hole 58 of the main body part 46 to extend from the inner side L1 to the outer side **L2.** The locking member 54 is elastic, and the mounting feature 56 is configured to be inserted into the mounting part 50 (hole) of the rack 22 in response to an elastic force F of the locking member 54, such that the mounting feature 56 is configured to abut against a second wall K2 (second hole wall) of the mounting part 50, in order to prevent the engaging structure 48 from being disengaged from the rack 22. In other words, the first fitting device 28 is locked to the first side frame 24 of the rack 22, and unable to be detached from the first side frame 24 of the rack 22 (as shown in FIG. 4).

Preferably, the first wall K1 and the second wall K2 are two opposite walls, such as a rear wall and a front wall of the mounting part 50 (as shown in FIG. 4), but the present invention is not limited thereto.

Preferably, the locking member 54 comprises a connecting section 60, an operating section 62 and an elastic section 64 connected between the connecting section 60 and the operating section 62 (as shown in FIG. 3). The connecting section 60 is connected (such as fixedly connected) to the main body part 46. The elastic section 64 is arranged with the mounting feature 56. The operating section 62 is connected to the elastic section 64. A user can operate the operating section 62 to move the elastic section 64. The operating section 62 is bent relative to the elastic section 64, such that the user can easily pull the operating section 62 to move the elastic section 64.

Preferably, a limiting feature 66 (as shown in FIG. 3) is arranged at the inner side L1 of the main body part 46 configured to prevent the elastic section 64 from being excessively moved when the user applies an operating force J along a direction opposite to a direction of the elastic force F.

Preferably, at least one first connecting feature 68 is arranged adjacent to the first end part 44a, and at least one second connecting feature 70 is arranged adjacent to the second end part 44b.

Preferably, the first end part 44a is arranged with a first connecting base 72 substantially perpendicularly bent relative to the main body part 46. For example, the first connecting base 72 is bent relative to the main body part 46 along a direction away from the first side frame 24 of the rack 22 (that is, a direction toward the second side frame 26 of the rack 22). The first connecting feature 68 is arranged on the first connecting base 72. Similarly, the second end part 44b is arranged with a second connecting base 74 substantially perpendicularly bent relative to the main body part 46. For example, the second connecting base 74 is bent relative to the main body part 46 along the direction away from the first side frame 24 of the rack 22 (that is, the direction toward the second side frame 26 of the rack 22). The second connecting feature 70 is arranged on the second connecting base 74.

Preferably, at least one of the first connecting feature 68 and the second connecting feature 70 is a mounting hole. In the present example, the first connecting feature 68 and the second connecting feature 70 are both mounting holes. The mounting holes can be square holes, round holes or screw holes, but the present invention is not limited thereto.

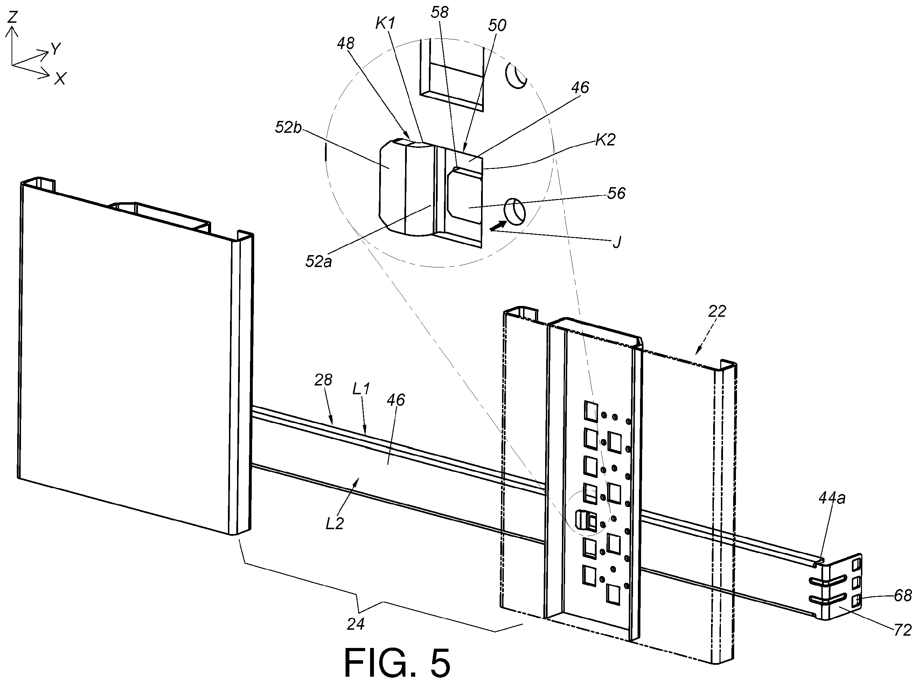

As shown in FIG. 5 , when the user is going to detach the first fitting device 28 from the first side frame 24 of the rack 22, the user can apply the operating force J to the operating section 62 in order to overcome the elastic force F of the locking member 54, so as to move the elastic section 64 inward, such that the mounting feature 56 is moved away from the second wall K2 (second hole wall) of the mounting part 50 (for example, the mounting feature 56 is laterally offset from the second wall K2 of the mounting part 50). As such, the engaging structure 48 is able to be detached from the first wall K1 of the mounting part 50 of the rack 22. In other words, the first fitting device 28 can be detached from the first side frame 24 of the rack 22 at this time.

Moreover, the manner of detaching the second fitting device 30 from the second side frame 26 is substantially identical to the manner of detaching the first fitting device 28 from the first side frame 24, thus no further illustration is provided for simplicity.

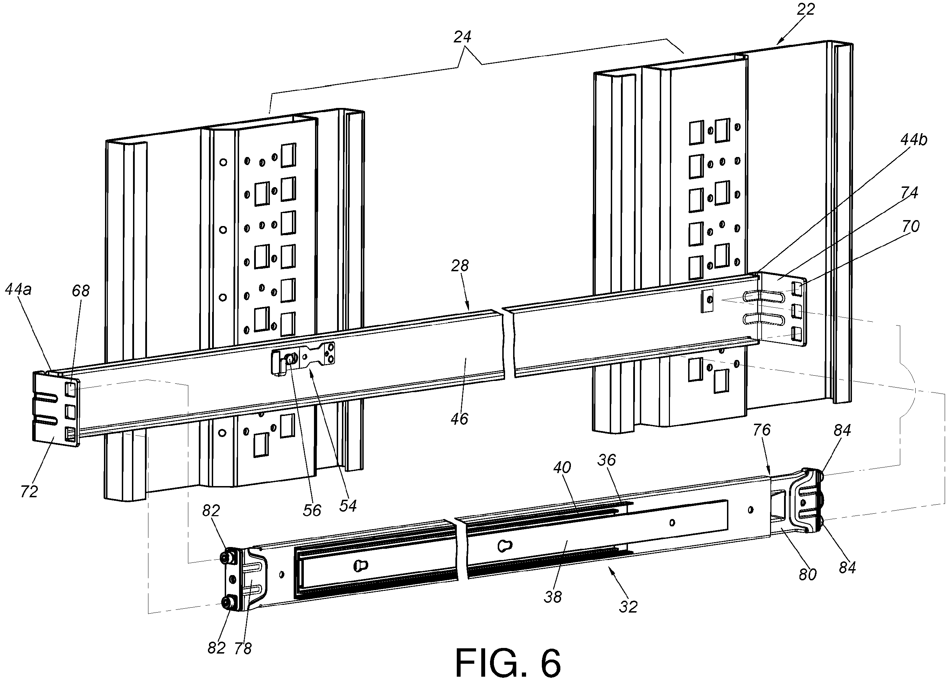

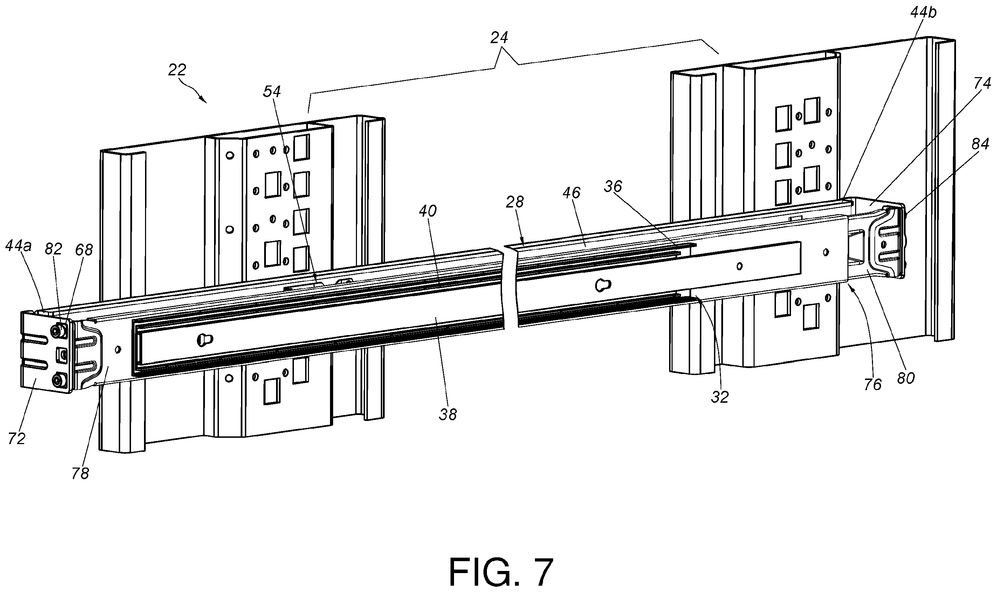

As shown in FIG. 6 and FIG. 7 , the first fitting device 28 is mounted to the rack 22 (the first side frame 24 of the rack 22), and the first slide rail assembly 32 is configured to be mounted between the first connecting feature 68 and the second connecting feature 70 of the first fitting device 28. Specifically, the first rail 36 of the first slide rail assembly 32 is arranged with a bracket mechanism 76, and the bracket mechanism 76 comprises a first bracket 78 and a second bracket 80 longitudinally movable relative to each other. The first bracket 78 is arranged with at least one first connecting part 82 configured to be connected to the first connecting feature 68 of the first fitting device 28. The second bracket 80 is arranged with at least one second connecting part 84 configured to be connected to the second connecting feature 70 of the first fitting device 28.

Moreover, the manner of mounting the second slide rail assembly 34 to the second fitting device 30 is substantially identical to the manner of mounting the first slide rail assembly 32 to the first fitting device 28, thus no further illustration is provided for simplicity.

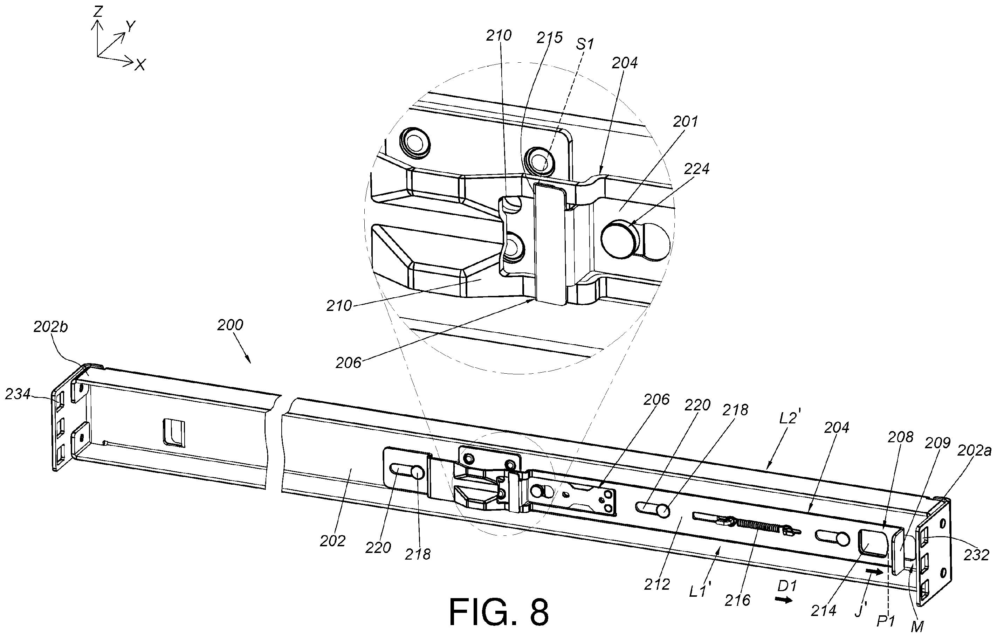

FIG. 8 shows a second fitting device 200 (structural configuration of the first fitting device is substantially identical to or symmetric to structural configuration of the second fitting device 200) according to an embodiment of the present invention. Different from the second fitting device 30 (or the first fitting device 28) of the example, a main body part 202 of the second fitting device 200 is further arranged with an operating member 204, and the operating member 204 is configured to drive a locking member 206 to move.

Preferably, the main body part 202 has a first end part 202a and a second end part 202b, such as a front end part and a rear end part, and the operating member 204 comprises an operating part 208 adjacent to the first end part 202a, such that it is convenient for a user standing in front of the second fitting device 200 (or the first fitting device) to operate the operating part 208 to drive the locking member 206 to move for unlocking the second fitting device 200. Preferably, the operating part 208 further has a bent section 209 to allow the user to easily apply an operating force J' from an inner side L1' of the main body part 202 to pull the operating member 204 to drive the locking member 206 to move.

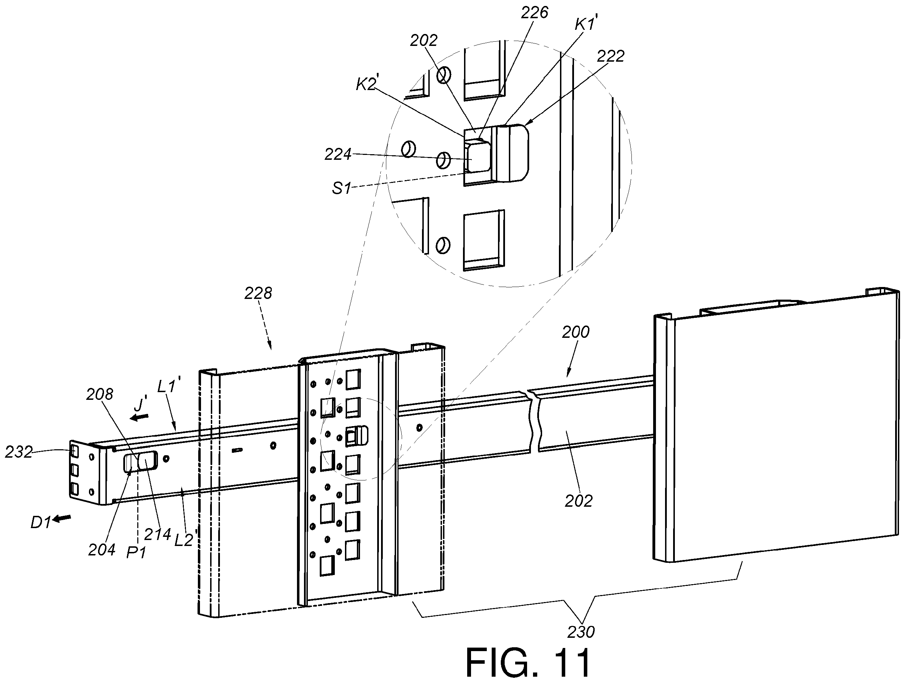

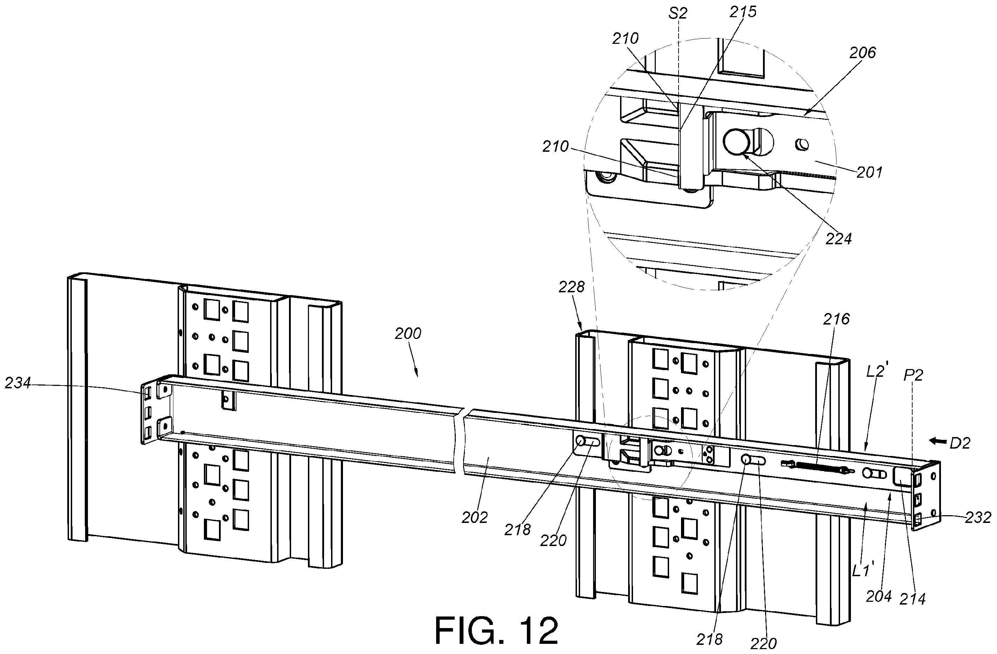

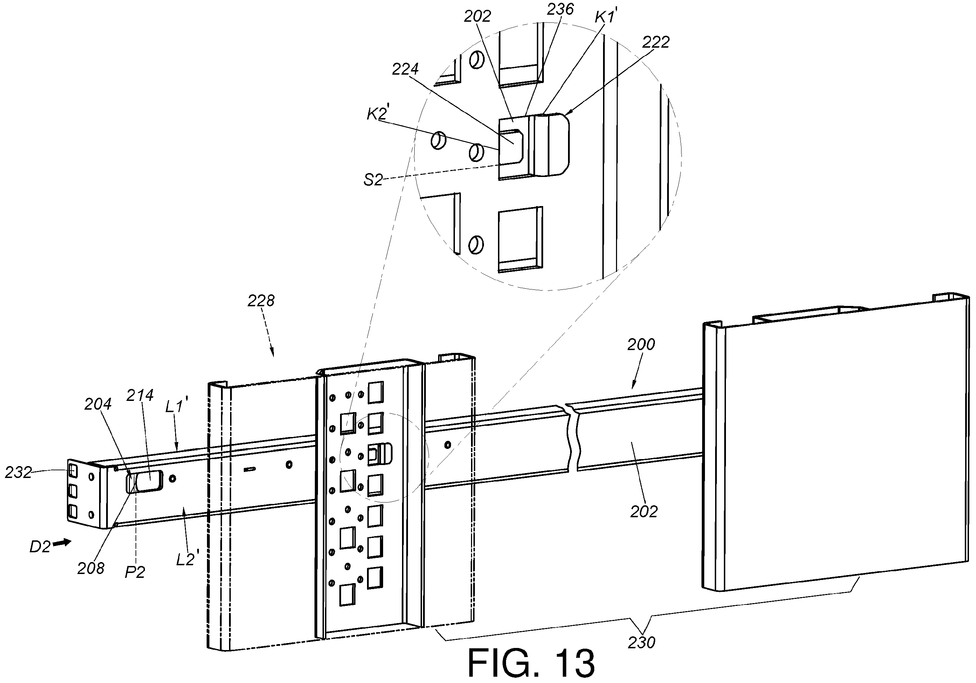

Preferably, the main body part 202 is formed with a predetermined space M (such as a through hole or a notch) communicating the inner side L1' and an outer side L2' of the main body part 202, and the operating member 204 further comprises at least one driving part 210 (for example, the driving part 210 has an inclined surface or an arc surface, but the present invention is not limited thereto) and an extension part 212 connected between the driving part 210 and the operating part 208. The operating part 204 has a predetermined hole 214 adjacent to the predetermined space M of the main body part 202 (for example, the predetermined hole 214 corresponds to the predetermined space M), such that the user can easily apply the operating force J' to the operating part 208 from the inner side L1' or the outer side L2' of the main body part 202 to operate the operating member 204 to move from a first predetermined position P1 (as shown in FIG. 8 and FIG. 11) to a second predetermined position P2 (as shown in FIG. 12 and FIG. 13) along a first predetermined direction D1, so as to drive an elastic section 201 of the locking member 206 to move (such as deflect) inward to switch from a first state S1 (such as a locking state as shown in FIG. 8 and FIG. 11) to a second state S2 (such as an unlocking state as shown in FIG. 12 and FIG. 13), such that a mounting feature 224 on the elastic section 201 of the locking member 206 is moved inward to be away from a second wall K2' of a mounting part 236 of a rack 228 (as shown in FIG. 12 and FIG. 13).

Preferably, the second fitting device 200 further comprises a return elastic member 216. The operating member 204 is configured to be held at the first predetermined position P1 in response to a return elastic force of the return elastic member 216.

Preferably, the operating member 204 is longitudinally movable relative to the main body part 202 within a limited range defined by a plurality of pairs of a first limiting structure 218 and a second limiting structure 220. The first limiting structure 218 and the second limiting structure 220 are a combination of a protruded part (such as a connecting pin or a connecting bolt) and an elongated hole. For example, the protruded part is configured to pass through a portion of the elongated hole.

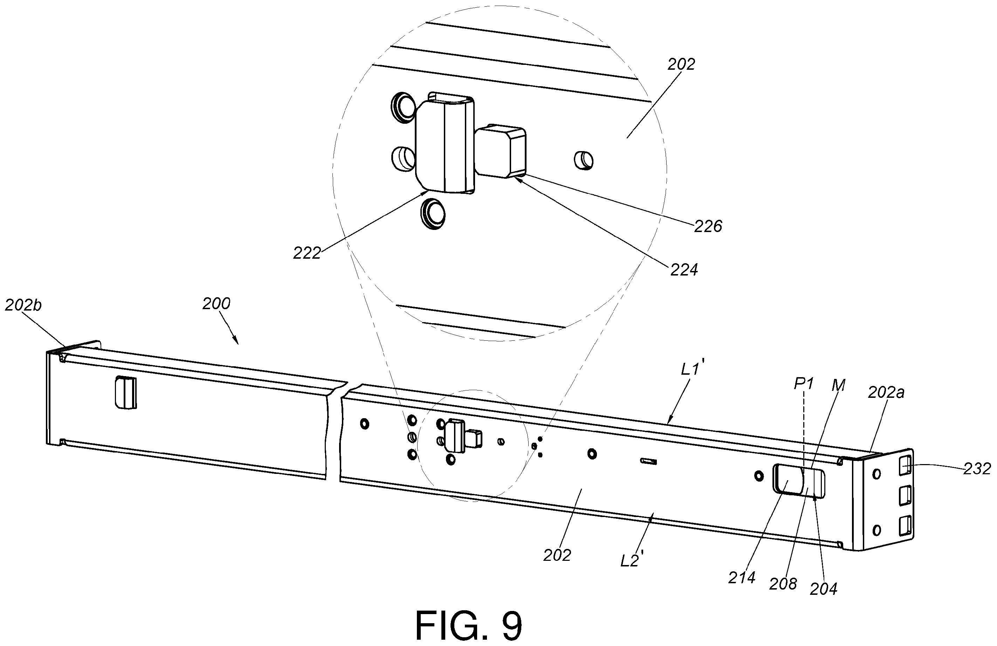

As shown in FIG. 9, similar to the example, the outer side L2' of the main body part 202 is arranged with an engaging structure 222, and the mounting feature 224 on the locking member 206 is configured to pass through an auxiliary hole 226 of the main body part 202 to extend from the inner side L1' to the outer side L2' .

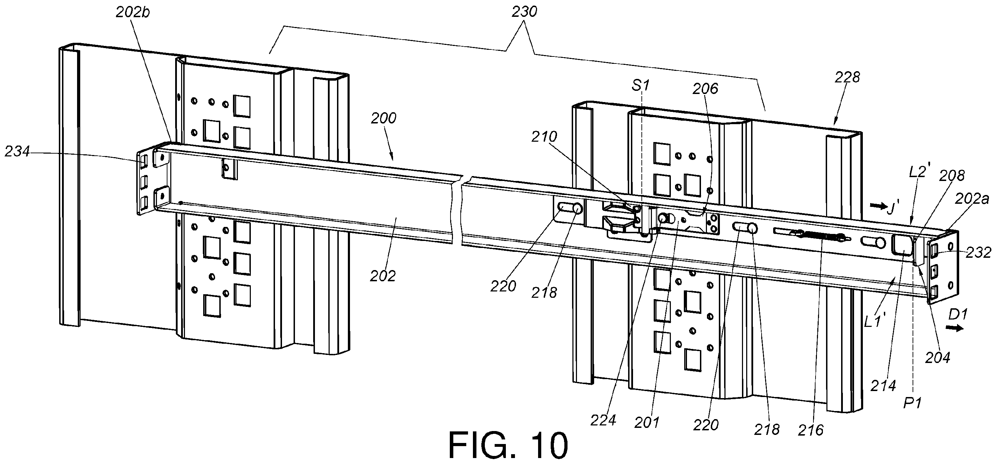

As shown in FIG. 10 and FIG. 11, the second fitting device 200 is mounted to the second side frame 230 of the rack 228 (such mounting configuration has been disclosed in the example, no further illustration is provided for simplicity).

As shown in FIG. 10 to FIG. 13, the second fitting device 200 is mounted to the second side frame 230 of the rack 228 without mounting a second slide rail assembly between a first connecting feature 232 and a second connecting feature 234 of the second fitting device 200. In the embodiment, the user can easily operate the operating member 204 to drive the locking member 206 (the elastic section 201 of the locking member 206) to move.

Furthermore, when the user is going to detach the second fitting device 200 from the second side frame 230 of the rack 228, the user can apply the operating force J' (as shown in FIG. 10 and FIG. 11) to the operating member 204 (the operating part 208 of the operating member 204) from the inner side L1' or the outer side L2' of the main body part 202 in order to operate the operating member 204 to move from the first predetermined position P1 (as shown in FIG. 10 and FIG. 11) to the second predetermined position P2 (as shown in FIG. 12 and FIG. 13), such that the driving part 210 of the operating member 204 is configured to contact a corresponding part 215 of the locking member 206 (as shown in FIG. 12), so as to drive the elastic section 201 of the locking member 206 to move inward to switch from the first state S1 (shown in FIG. 10 and FIG. 11) to the second state S2 (as shown in FIG. 12 and FIG. 13). As such, the mounting feature 224 is moved toward the inner side L1' of the main body part 202 to be away from the second wall K2' (second hole wall) of the mounting part 236 (hole) of the rack 228 (for example, the mounting feature 224 is laterally offset from the second wall K2' of the mounting part 236 as shown in FIG. 13). Therefore, the engaging structure 222 is able to be detached from the first wall K1' (first hole wall) of the mounting part 236 of the rack 228. In other words, the second fitting device 200 can be detached from the second side frame 230 of the rack 228 at this time (as shown in FIG. 13).

In addition, once the user stops applying the operating force J' to the operating member 204, the return elastic force of the return elastic member 216 is configured to drive the operating member 204 to move from the second predetermined position P2 (as shown in FIG. 12 and FIG. 13) back to the first predetermined position P1 (as shown in FIG. 10 and FIG. 11) along a second predetermined direction D2 opposite to the first predetermined direction D1, and the locking member 206 is moved to switch from the second state S2 to the first state S1.

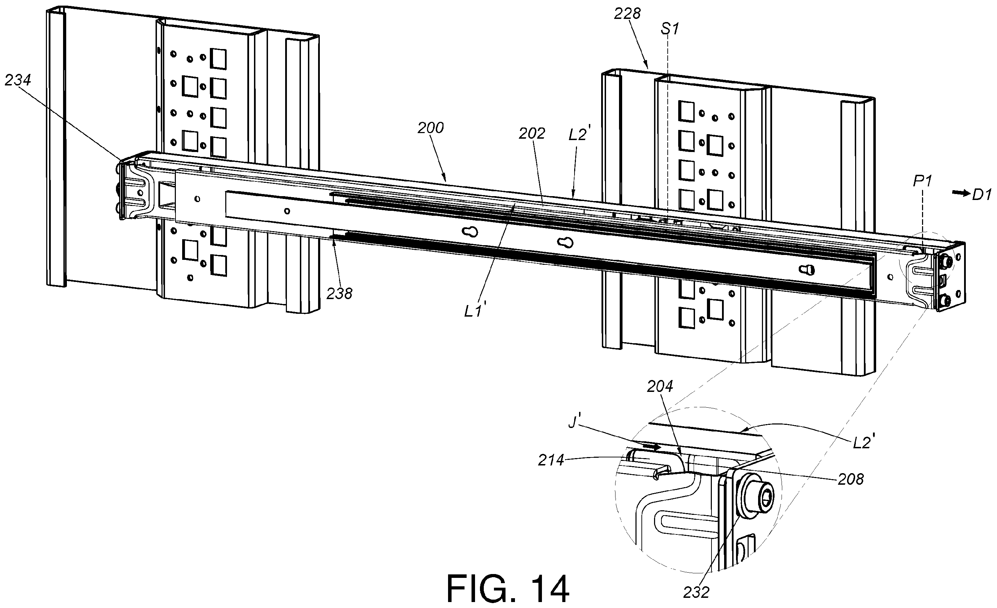

As shown in FIG. 14, when a second slide rail assembly 238 is mounted between the first connecting feature 232 and the second connecting feature 234 of the second fitting device 200, the second first slide rail assembly 238 is configured to cover most of the inner side L1' of the main body part 202 of the second fitting device 200. Therefore, the user cannot easily operate the operating member 204 (the operating part 208 of the operating member 204) from the inner side L1' of the main body part 202. At this time, the user's finger can insert into the predetermined hole 214 to extend from the outer side L2' of the main body part 202 to the inner side L1' of the main body part 202 to apply the operating force J' to the operating part 208, in order to operate the operating member 204 to move from the first predetermined position P1 to the second predetermined position P2 along the first predetermined direction D1, such that the mounting feature 224 is moved toward the inner side L1' to allow the engaging structure 222 to be detached from the rack 228, so as to detach the second fitting device 200 from the rack 228 (such configuration has been disclosed above, no further illustration is provided for simplicity).

## Claims

1. Afitting device (200), configured to be mounted to a rack (228), the fitting device (200) comprising:
a first end part;
a second end part;
a main body part (202) connected between the first end part and the second end part, wherein the main body part (202) is arranged with an engaging structure (222) configured to be engaged to the rack (228);
a locking member (206) arranged on the main body part (202);
a mounting feature (224) arranged on the locking member (206) and configured to lock the engaging structure (222) to the rack (228), in order to prevent the engaging structure (222) from being disengaged from the rack (228); and
an operating member (204) configured to drive the locking member (206) to move;
wherein the main body part (202) has an inner side (L1') and an outer side (L2'), the locking member (206) is arranged at the inner side of the main body part (202), and the mounting feature (224) is extended from the inner side (L1') to the outer side (L2') ; and
wherein the main body part (202) is formed with a predetermined space (M) communicated with the inner side (L1') and the outer side (L2'), and the operating member (204) has a predetermined hole (214) adjacent to the predetermined space (M) of the main body part (202), such that the user can selectively apply an operating force (J') to an operating part (208) of the operating member (204) from either the inner side (L1') or the outer side (L2') of the main body part (202) to operate the operating member (204) to move from a first predetermined position (P1) to a second predetermined position (P2) along a first predetermined direction (D1), so as to drive an elastic section (201) of the locking member (206) to move inward to switch from a first state (S1) to a second state (S2), such that the mounting feature (224) on the elastic section (201) of the locking member (206) is moved inward to be away from a wall (K2') of a mounting part (236) of the rack (228) .

2. The fitting device of claim 1, **characterized in that** the operating member (204) is arranged on the main body part (202), and the operating part (208) is adjacent to the first end part.

3. The fitting device of any of claims 1-2, further **characterized by** a return elastic member (216) configured to provide a return elastic force to the operating member (204).

4. The fitting device of any of claims 1-3, **characterized in that** a first connecting feature (232) is arranged adjacent to the first end part, and a second connecting feature (234) is arranged adjacent to the second end part; wherein a slide rail assembly (238) is configured to be mounted between the first connecting feature (232) and the second connecting feature (234); wherein the first end part is arranged with a first connecting base substantially perpendicularly bent relative to the main body part (202), the first connecting feature (232) is arranged on the first connecting base; wherein the second end part is arranged with a second connecting base (74) substantially perpendicularly bent relative to the main body part (202), the second connecting feature (234) is arranged on the second connecting base.

## Patentansprüche

1. Beschlagvorrichtung (200), die konfiguriert ist, um an einem Gestell (228) montiert zu werden, wobei die Beschlagvorrichtung (200) aufweist:
ein erstes Endteil;
ein zweites Endteil;
einen Haupt-Körper-Teil (202), der zwischen dem ersten Endteil und dem zweiten Endteil verbunden ist, wobei der Haupt-Körper-Teil (202) mit einer Eingriffsstruktur (222) angeordnet ist, die konfiguriert ist, um mit dem Gestell (228) in Eingriff gebracht zu sein / werden;
ein Verriegelungselement (206), das am Haupt-Körper-Teil (202) angeordnet ist;
eine Montageeinrichtung (224), welche am Verriegelungselement (206) angeordnet ist und konfiguriert ist, um die Eingriffsstruktur (222) an das Gestell (228) zu verriegeln, um zu verhindern, dass sich die Eingriffsstruktur (222) vom Gestell (228) löst; und
ein Betätigungselement (204), das konfiguriert ist, um das Verriegelungselement (206) zu einer Bewegung anzutreiben;
wobei der Haupt-Körper-Teil (202) eine innere Seite (L1') und eine äußere Seite (L2') hat, das Verriegelungselement (206) an der inneren Seite des Haupt-Körper-Teils (202) angeordnet ist und sich die Montageeinrichtung (224) von der inneren Seite (L1') zur äußeren Seite (L2') erstreckt; und
wobei der Haupt-Körper-Teil (202) mit einem vorbestimmten Raum (M) ausgebildet ist, der mit der inneren Seite (L1') und der äußeren Seite (L2') kommuniziert, und das Betätigungselement (204) ein vorbestimmtes Loch (214) hat, das benachbart zu dem vorbestimmten Raum (M) des Haupt-Körper-Teils (202) ist, sodass der Benutzer wahlweise eine Betätigungskraft (J') auf einen Betätigungsteil (208) des Betätigungselements (204) entweder von der inneren Seite (L1') oder der äußeren Seite (L2') des Haupt-Körper-Teils (202) ausüben kann, um das Betätigungselement (204) zu betätigen, um sich entlang einer ersten vorbestimmten Richtung (D1) von einer ersten vorbestimmten Position (P1) zu einer zweiten vorbestimmten Position (P2) zu bewegen, um einen elastischen Abschnitt (201) des Verriegelungselements (206) anzutreiben, sich nach innen zu bewegen, um von einem ersten Zustand (S1) in einen zweiten Zustand (S2) zu wechseln, sodass die Montageeinrichtung (224) am elastischen Abschnitt (201) des Verriegelungselements (206) nach innen bewegt wird, um von einer Wand (K2') eines Montageteils (236) des Gestells (228) entfernt zu sein / werden.

2. Beschlagvorrichtung gemäß Anspruch 1, **dadurch gekennzeichnet, dass** das Betätigungselement (204) am Haupt-Körper-Teil (202) angeordnet ist und das Betätigungsteil (208) benachbart zu dem ersten Endteil ist

3. Beschlagvorrichtung gemäß irgendeinem der Ansprüche 1 bis 2, ferner **gekennzeichnet durch** ein Rückstell-Elastisch-Element (216), das konfiguriert ist, um dem Betätigungselement (204) eine Rückstell-Elastisch-Kraft bereitzustellen.

4. Beschlagvorrichtung gemäß irgendeinem der Ansprüche 1 bis 3, **dadurch gekennzeichnet, dass** eine erste Verbindungseinrichtung (232) benachbart zum ersten Endteil angeordnet ist und eine zweite Verbindungseinrichtung (234) benachbart zum zweiten Endteil angeordnet ist; wobei eine Laufschienenvorrichtung (238) konfiguriert ist, um zwischen der ersten Verbindungseinrichtung (232) und der zweiten Verbindungseinrichtung (234) montiert zu werden; wobei das erste Endteil mit einer ersten Verbindungsbasis angeordnet ist, die im Wesentlichen senkrecht zum Haupt-Körper-Teil (202) gebogen ist, und die erste Verbindungseinrichtung (232) an der ersten Verbindungsbasis angeordnet ist; wobei das zweite Endteil mit einer zweiten Verbindungsbasis (74) angeordnet ist, die im Wesentlichen senkrecht zum Haupt-Körper-Teil (202) gebogen ist, und die zweite Verbindungseinrichtung (234) an der zweiten Verbindungsbasis angeordnet ist.

## Revendications

1. Dispositif de raccord (200), configuré pour être monté sur un rack (228), le dispositif de raccord (200) comprenant :
une première partie d'extrémité ;
une deuxième partie d'extrémité ;
une partie de corps principal (202) reliée entre la première partie d'extrémité et la deuxième partie d'extrémité, la partie de corps principal (202) étant agencée avec une structure de prise (222) configurée pour venir en prise avec le rack (228) ;
un élément de verrouillage (206) disposé sur la partie de corps principal (202) ;
une caractéristique de montage (224) disposée sur l'élément de verrouillage (206) et configurée pour verrouiller la structure de prise (222) sur le rack (228), afin d'empêcher la structure de prise (222) de venir hors prise du rack (228) ; et
un élément d'actionnement (204) configuré pour entraîner un déplacement de l'élément de verrouillage (206) ;
dans lequel la partie de corps principal (202) présente une face interne (L1') et une face externe (L2'), l'élément de verrouillage (206) est disposé sur la face interne de la partie de corps principal (202), et la caractéristique de montage (224) s'étend de la face interne (L1') vers la face externe (L2') ; et
dans lequel la partie de corps principal (202) est formée avec un espace prédéterminé (M) communiquant avec la face interne (L1') et la face externe (L2'), et l'élément d'actionnement (204) comporte un trou prédéterminé (214) adjacent à l'espace prédéterminé (M) de la partie de corps principal (202), de telle sorte que l'utilisateur puisse appliquer de manière sélective une force d'actionnement (J') à une partie d'actionnement (208) de l'élément d'actionnement (204) depuis soit la face interne (L1'), soit la face externe (L2') de la partie de corps principal (202) pour actionner l'élément d'actionnement (204) pour un déplacement d'une première position prédéterminée (P1) vers une deuxième position prédéterminée (P2) le long d'une première direction prédéterminée (D1), de manière à entraîner une section élastique (201) de l'élément de verrouillage (206) à se déplacer vers l'intérieur pour passer d'un premier état (S1) à un deuxième état (S2), de sorte que la caractéristique de montage (224) sur la section élastique (201) de l'élément de verrouillage (206) soit déplacée vers l'intérieur pour s'éloigner d'une paroi (K2') d'une partie de montage (236) du rack (228).

2. Dispositif de raccord selon la revendication 1, **caractérisé en ce que** l'élément d'actionnement (204) est disposé sur la partie de corps principal (202), et la partie d'actionnement (208) est adjacente à la première partie d'extrémité.

3. Dispositif de raccord selon l'une quelconque des revendications 1 à 2, **caractérisé en outre par** un élément élastique de rappel (216) configuré pour fournir une force élastique de rappel à l'élément d'actionnement (204).

4. Dispositif de raccord selon l'une quelconque des revendications 1 à 3, **caractérisé en ce qu'**une première caractéristique de connexion (232) est disposée de manière adjacente à la première partie d'extrémité, et une deuxième caractéristique de connexion (234) est disposée de manière adjacente à la deuxième partie d'extrémité ; dans lequel un ensemble de glissière (238) est configuré pour être monté entre la première caractéristique de connexion (232) et la deuxième caractéristique de connexion (234) ; dans lequel la première partie d'extrémité est agencée avec une première base de connexion pliée sensiblement perpendiculairement par rapport à la partie de corps principal (202), la première caractéristique de connexion (232) étant disposée sur la première base de connexion ; dans lequel la deuxième partie d'extrémité est agencée avec une deuxième base de connexion (74) pliée sensiblement perpendiculairement par rapport à la partie de corps principal (202), la deuxième caractéristique de connexion (234) étant disposée sur la deuxième base de connexion.
